(19) Europäisches Patentamt

European Patent Office

Office européen des brevets

(11) **EP 0 967 630 B1**

(12) **EUROPÄISCHE PATENTSCHRIFT**

(45) Veröffentlichungstag und Bekanntmachung des Hinweises auf die Patenterteilung:
**13.08.2003 Patentblatt 2003/33**

(51) Int Cl.7: **H01J 37/05**, H01J 37/153, H01J 37/26

(21) Anmeldenummer: **99111296.2**

(22) Anmeldetag: **10.06.1999**

(54) **Elektronenmikroskop mit einem abbildenden magnetischen Energiefilter**

Electron microscope with imaging magnetic filter

Microscope électronique avec filtre magnétique pour l'obtention d'images

(84) Benannte Vertragsstaaten:
**DE NL**

(30) Priorität: **27.06.1998 DE 19828741**

(43) Veröffentlichungstag der Anmeldung:
**29.12.1999 Patentblatt 1999/52**

(73) Patentinhaber: **LEO Elektronenmikroskopie GmbH**
**73446 Oberkochen (DE)**

(72) Erfinder:
• **Krahl, Dieter Dr.**
**12247 Berlin (DE)**
• **Kujawa, Stephan Dr.**
**10709 Berlin (DE)**

(74) Vertreter: **Gnatzig, Klaus et al**
**Carl Zeiss**
**Patentabteilung**
**73446 Oberkochen (DE)**

(56) Entgegenhaltungen:
• **KUJAWA S ET AL: "SECOND-RANK ABERRATIONS OF A MAGNETIC IMAGING ENERGY FILTER: MEASUREMENT AND CORRECTION" OPTIK,DE,WISSENSCHAFTLICHE VERLAG GMBH.STUTTGART, Bd. 86, Nr. 2, 1. November 1990 (1990-11-01), Seiten 39-46, XP000176694 ISSN: 0030-4026**

**Beschreibung**

In abbildenden Energiefiltern für die Transmissionselektronenmikroskopie, wie diese beispielsweise in der US-A 4 760 261 für ein sogenanntes Alpha-Filter und in der US-A 4 740 704 für ein sogenanntes Omega-Filter beschrieben sind, verursachen Aberrationen laterale Auflösungsverluste in der achromatischen Bildebene und in der Dispersionsebene, in der das Energiespektrum der das Objekt transmittierten Elektronen entsteht, und damit einen Verlust an Energieauflösung. Die dominierenden Aberrationen sind von zweiter Stufe. Sie werden beschrieben durch 18 linear unabhängige Aberrationskoeffizienten. Die Fehlfokussierungen sind dabei quadratisch oder bilinear von geometrischen Parametern wie Achsenabstand der Bildpunkte, und Bestrahlungsapertur und von den Abweichungen der Elektronenenergie von der Nominalenergie abhängig.

Aus einer Arbeit von H. Rose und D. Krahl in Springer Series in Optical Science, Band 71, Edited by L. Reimer, Seiten 43-149 (Kapitel Energy Filtering Transmission Electron Microscopy) und aus der Dissertation von Herrn Stefan Lanio "Optimierung abbildender Energiefilter für die analytische Elektronenmikroskopie", TH Darmstadt, 1986, ist es bekannt, daß bei einem symmetrischen Aufbau des Filters und durch geschickte Wahl der Führung der Fundamentalbahnen durch das Filter sowie den Einsatz von Hexapolkorrektoren analog zum Oberbegriff des Anspruchs 1 die geometrischen Fehler zweiter Ordnung (Seidelsche Aberrationen) in der achromatischen Bildebene und in der Dispersionsebene korrigiert werden können. Durch die Hexapolkorrektur verschwinden in der achromatischen Bildebene gleichzeitig die chromatischen Aberrationen, die vom Achsenabstand der Bildpunkte und von der Energieabweichung abhängig sind. Unkorrigiert bleiben dagegen die achsialen Farbfehler in der achromatischen Bildebene und in der Dispersionsebene. Der Einfluß des Farbfehlers in der achromatischen Bildebene auf die laterale Auflösung kann auch bei Wahl relativ großer Energiefenster vernachlässigt werden, da er gering ist. Die in der dispersiven Richtung wirkende Komponente des achsialen Farbfehlers in der Dispersionsebene ($C_{\gamma\gamma\kappa}$) bewirkt in Verbindung mit der Energiedispersion (D) des Energiefilters eine Neigung der Fokusebene des Energieverlustspektrums um einen Winkel $\Theta$ gegen die Dispersionsebene entsprechend der Gleichung

$$\tan \Theta = C_{\gamma\gamma\kappa}/C_{\gamma\kappa},$$

wobei $C_{\gamma\kappa}$ der Dispersionskoeffizient ist, der sich aus $D = C_{\gamma\kappa}/E$ ergibt. Diese Neigung der Fokusebene wirkt sich bei einer parallelen Registrierung von Energiespektren, bei der die Dispersionsebene mittels einer Rundlinse oder einer Linsenkombination auf eine Detektorebene, z.B. eine Photoplatte oder eine CCD-Kamera abgebildet wird, nachteilig aus. Denn in Folge der Neigung der Fokusebene gegen die Dispersionsebene durch den achsialen Farbfehler muß eine Verschlechterung der Energieauflösung mit steigendem Energieverlust in Kauf genommen werden. Dieser Effekt tritt verstärkt auf, wenn relativ große Bildfelder, die durch einen großen Achsenabstandsparameter $\gamma$ gekennzeichnet sind, zum Energiespektrum beitragen. Deshalb ist bereits in der o.g. Arbeit von H. Rose und D. Krahl festgestellt worden, daß zur parallelen Registrierung von Energiespektren der achsiale Farbfehler korrigiert werden muß. Konkrete Vorschläge für die Korrektion des achsialen Farbfehlers werden jedoch nicht geliefert.

In der US-A 5 448 063 ist desweiteren ein Omega-Filter beschrieben, bei dem durch insgesamt neun Hexapolkorrektoren sämtliche geometrischen Aberrationen zweiter Ordnung als auch alle chromatischen Aberrationen zweiter Stufe, und damit auch der achsiale Farbfehler, korrigiert sein sollen. Die dort angegebenen Beispiele für Filter sind jedoch in der achromatischen Bildebene nicht stigmatisch, d.h. die eingangsseitige Bildebene des Filters wird vom Filter astigmatisch in die achromatische Bildebene abgebildet. Die Fokusdifferenzen zwischen den Schnitten senkrecht und parallel zu den magnetischen Dipolfeldern der Umlenkmagnete betragen bei den Filtern 26,4 mm bzw. 32,7 mm. Diese Filter sind damit für Anwendungen als abbildende Filter, bei denen ein energiegefiltertes Objektbild in die Detektorebene abgebildet wird, nicht geeignet.

Es ist das Ziel der vorliegenden Erfindung, ein Elektronenmikroskop mit einem abbildenden magnetischen Energiefilter anzugeben, das sowohl für die Abbildung energiegefilterter Objektbilder oder Beugungsbilder in eine Detektorebene als auch für eine Abbildung der Dispersionsebene in eine Detektorebene für eine parallele Registrierung des Energiespektrums geeignet ist.

Dieses Ziel wird durch ein Elektronenmikroskop mit den Merkmalen des Anspruches 1 gelöst. Vorteilhafte Ausgestaltungen der Erfindung ergeben sich aus den Merkmalen der abhängigen Ansprüche.

Das erfindungsgemäße Elektronenmikroskop weist ein abbildendes magnetisches Energiefilter mit symmetrisch zu einer Mittenebene angeordneten magnetischen Umlenksystemen auf. Das Energiefilter bildet eine erste eingangsseitige Ebene - die Eingangsbildebene - stigmatisch und achromatisch in eine erste ausgangsseitige Ebene - die achromatische Bildebene - ab. Gleichzeitig bildet das Energiefilter eine zweite eingangsseitige Ebene - die Eingangsbeugungsebene - stigmatisch und dispersiv in eine zweite ausgangsseitige Ebene - die Dispersionsebene - ab.

In Strahlrichtung gesehen folgt dem Energiefilter ein Projektivsystem nach, durch das wahlweise die Dispersionsebene oder die achromatische Bildebene vergrößert in eine Detektorebene abbildbar ist. Bei Abbildung der achromatischen Bildebene in die Detektorebene erfolgt entweder eine energiegefilterte Objektregistrierung - nämlich dann, wenn das Objekt in die Eingangsbildebene des Energiefilters abgebildet ist - oder eine energiegefilterte Registrierung des Objektbeugungsdiagrammes - wenn die Fourierebene des das Objekt abbildenden Objektivs in die Eingangsbildebene des Energiefilters abgebildet ist. Bei Abbildung der Dispersionsebene in die Detektorebene erfolgt eine parallele Registierung des nach der Wechselwirkung mit dem Objekt resultierenden Energiespektrums der Elektronen.

Mindestens zwischen den Umlenksystemen des Energiefilters sind Hexapolkorrektoren vorgesehen. Zusätzliche Hexapolkorrektoren können außerdem in der Eingangsbildebene und in der achromatischen Bildebene angeordnet sein. Bei der Umschaltung zwischen der Abbildung der achromatischen Bildebene und der Abbildung der Dispersionsebene in die Detektorebene erfolgt eine Umschaltung der Erregungen eines Teils der Hexapolkorrketoren. Bei einer Abbildung der achromatischen Bildebene sind die Hexapole üblicherweise so erregt, daß sämtliche geometrischen Fehler zweiter Ordnung (Seidelsche Aberrationen) in der achromatischen Bildebene korrigiert sind. Bei Abbildung der Dispersionsebene in die Detektorebene sind dagegen die Hexapole so erregt, daß neben dem Öffnungsfehler zweiter Ordnung auch der achsiale Farbfehler des Energiefilters oder des Systems aus Energiefilter und Projektivsystem in der Dispersionsebene korrigiert ist. Andere, bei Abbildung der Dispersionsebene in die Detektorebene nicht störende, geometrische Bildfehler zweiter Ordnung in der achromatischen Bildebene werden dagegen zugelassen.

Der Erfindung liegt damit die Erkenntnis zugrunde, daß eine Korrektur des achsialen Farbfehlers bei gleichzeitiger Beibehaltung der Korrektur des Öffnungsfehlers zweiter Orndung ohne zusätzliche Hexapole durch entsprechend geänderte Erregung der für eine Korrektur der geometrischen Fehler zweiter Ordnung ohnehin vorhandenen Hexapole möglich ist. Zwar treten aufgrund der geänderten Hexapolerregungen dann geometrische Bildfehler zweiter Ordnung auf, jedoch wurde gleichzeitig erkannt, daß diese geometrischen Bildfehler bei einer Abbildung der Dispersionsebene in die Detektorebene - und damit genau in den Fällen, in denen der achsiale Farbfehler sich negativ bemerkbar macht - nicht stören. Die Erfindung ermöglicht dadurch gegenüber Elektronenmikroskopen mit Energiefiltern, bei denen der achsiale Farbfehler unkorrigiert ist, eine wesentlich gesteigerte Energieauflösung bei einer parallelen Registrierung von Energieverlustspektren, ohne daß dadurch ein konstruktiver Zusatzaufwand resultieren würde.

Zur Neigung der Fokusebene in der Dispersionsebene tragen neben dem achsialen Farbfehler des Energiefilters auch außerachsiale Farbfehler des dem Energiefilter nachgeschalteten Projektivsystems bei. Je nach Vorzeichen und Größe dieser außerachsialen Farbfehler des Projektivsystems kann der achsiale Farbfehler des Energiefilters über eine entsprechende Erregung der Hexapole über- oder unterkorrigiert sein, so daß der verbleibende Rest des achsialen Farbfehlers des Energiefilters die außerachsialen Farbfehler des Projektivsystems kompensiert.

Bei einem konkreten Ausführungsbeispiel der Erfindung weist das Energiefilter vier magnetische Umlenkbereiche auf Jeweils zwei Hexapole sind zwischen dem ersten und zweiten Umlenkbereich und zwei weitere dazu symmetrische Hexapole zwischen dem dritten und vierten Umlenkbereich vorgesehen. Darüberhinaus ist ein zusätzlicher Hexapol in der Symmetrieebene des Energiefilters angeordnet. Bei der Umschaltung zwischen der Abbildung der Dispersionsebene und der Abbildung der achromatischen Bildebene wird nur die Erregung eines der beiden Hexapole zwischen dem ersten und zweiten Umlenkbereich, des dazu symmetrischen Hexapols zwischen dem dritten und vierten Umlenkbereich und des Hexapols in der Symmetrieebene geändert. Die Erregungen aller anderen Hexapole bleiben dagegen bei der Umschaltung unverändert. Die Erregungsänderung des Hexapols zwischen dem ersten und zweiten Umlenkbereich und des dazu symmetrischen Hexapols zwischen dem dritten und vierten Umlenkbereich ist gegenläufig zur Erregungsänderung des Hexapols in der Symmetrieebene.

Bei dem konkret beschriebenen Ausführungsbeispiel sind weiterhin zwei weitere Hexapole vorgesehen, von denen einer in der achromatischen Bildebene und der andere in der dazu konjugierten eingangsseitigen Ebene - der Eingangsbildebene des Energiefilters - angeordnet sind.

Die Erregung des Hexapols in der Symmetrieebene ist bei einer Abbildung der Dispersionsebene in die Detektorebene um einen Faktor 2 - 4, vorzugsweise um einen Faktor 2,81, größer als bei Abbildung der achromatischen Bildebene in die Detektorebene. Im Gegensatz dazu ist die Erregung des ersten Hexapols hinter dem ersten Umlenkbereich bei der Abbildung der achromatischen Bildebene in die Detektorebene um einen Faktor 1,5 - 2,5, vorzugsweise um einen Faktor 1,87, größer als bei Abbildung der Dispersionsebene in die Detektorebene.

Nachfolgend werden Einzelheiten der Erfindung anhand des in den Figuren dargestellten Ausführungsbeispiels näher erläutert. Im einzelnen zeigen:

Fig. 1      die Prinzipskizze eines erfindungsgemäßen Elektronenmikroskops im Schnitt;

Fig. 2a    den Strahlengang im unteren Teil des Elektronenmikroskops in Figur 1 bei Abbildung der achromatischen Bildebene in die Detektorebene;

Fig. 2b    den Strahlengang im unteren Teil des Elektronenmikroskops in Figur 1 bei Abbildung der Dispersionsebene in die Detektorebene und

Fig. 3    eine vergrößerte Prinzipskizze des Energiefilters beim Elektronenmikroskop in Figur 1 im Schnitt.

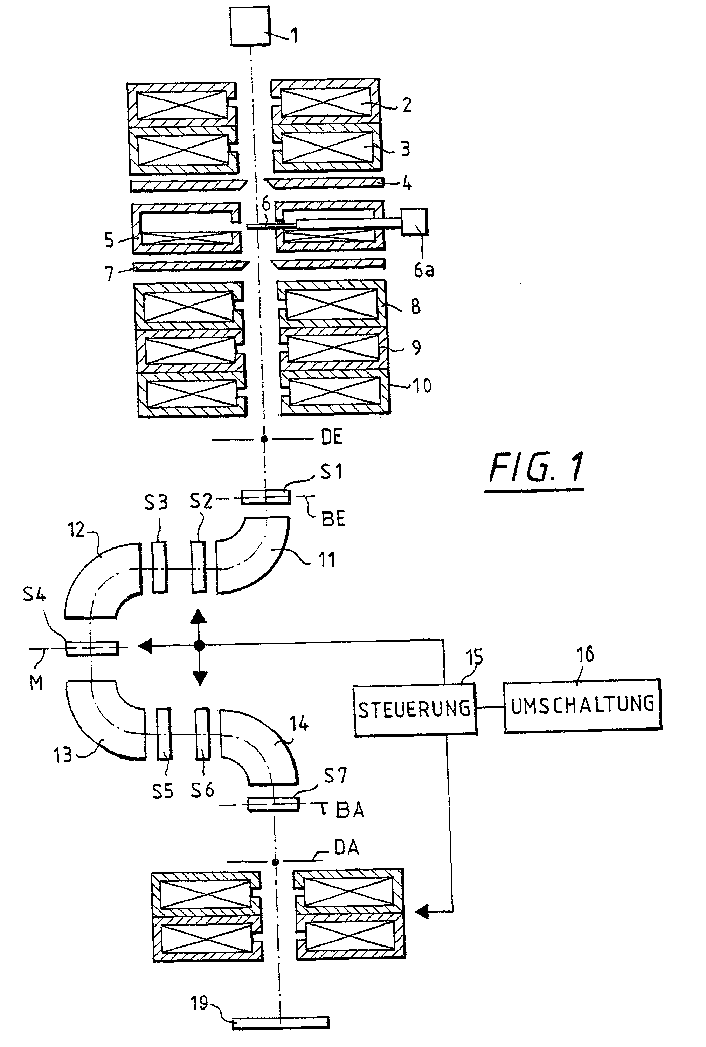

Der obere Teil des in der Figur 1 dargestellten Transmissionselektronenmikroskops weist einen konventionellen, aus der US-A 4 812 652 bekannten Aufbau auf Die Elektronenquelle ist mit (1) bezeichnet. Mittels eines der Elektronenquelle (1) nachgeschalteten zweistufigen Kondensors (2, 3) wird aus den aus der Elektronenquelle austretenden Elektronen ein kollimierter Elektronenstrahl erzeugt, dessen Apertur durch den Öffnungsdurchmesser der Aperturblende (4) bestimmt ist. Mit diesem kollimierten Elektronenstrahl wird das im Polschuhspalt des Objektivs (5) positionierte Objekt (6) beleuchtet. Für eine Manipulation des Objektes (6) ist dieses auf einem durch die Objektivlinse (5) hindurchgeführten Manipulator (6a) angeordnet.

Mittels drei der Objektivlinse (5) nachgeschalteten, ebenfalls als Magnetlinsen ausgebildeten Abbildungsstufen (8, 9, 10) wird ein vergrößertes Bild des Objektes (6) oder des Beugungsdiagrammes des Objektes (6) in der Eingangsbildebene (BE) des Energiefilters (11-14) erzeugt. Die Größe des übertragenen Bildfeldes wird dabei durch den Öffnungsdurchmesser der dem Objektiv (5) nachgeschalteten Feldblende (7) bestimmt. Die Abbildungsbedingungen vor dem Eintritt in das Energiefilter (11 - 14) entsprechen dabei den in der US-A 4 812 652 beschriebenen Abbildungsbedingungen, so daß unabhängig von der eingestellten Vergrößerung bei der Objektabbildung ein Bild des Objektes in der Eingangsbildebene (BE) des Energiefilters (11 - 14) und ein Bild der Elektronenquelle (1) in der Eingangsbeugungsebene (DE) des Energiefilters liegt. Bei der Aufnahme von Objektbeugungsdiagrammen liegt ein Bild der Elektronenquelle (1) in der Eingangsbildebene (BE) des Energiefilters und ein Bild des Objektes (6) in der Eingangsbeugungsebene (DE).

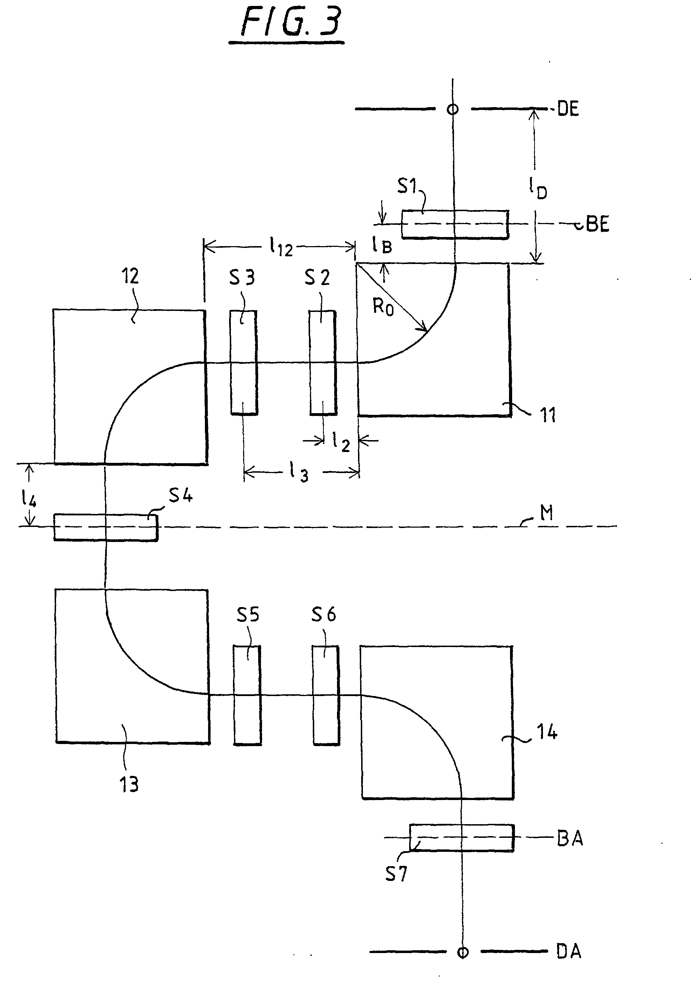

Das Energiefilter ist als sogenanntes Omega-Filter mit vier symmetrisch zu einer Mittenebene (M) angeordneten magnetischen Ablenkbereichen (11 - 14) ausgebildet, durch die die Elektronen auf einer Bahn geführt werden, die dem griechischen Buchstaben Ω ähnelt. Die Magnetfeldrichtung in den Umlenkbereich (11 - 14) ist dabei jeweils senkrecht zur Zeichenebene in Figur 1. Die in das Energiefilter eintretenden Elektronen mit der Sollenergie erfahren in jedem der vier Umlenkbereiche (11 - 14) eine Ablenkung um jeweils betragsmäßig gleiche Winkel, der bei dem weiter unten anhand der Figur 3 noch detaillierter beschriebenen Filter jeweils 90° beträgt. Wie man weiterhin anhand der Figur 1 erkennt, erfahren die Elektronen im ersten Umlenksystem (11) und im vierten Umlenksystem (14) sowohl betragsmäßig als auch richtungsmäßig die selbe Umlenkung, so daß über entsprechend groß ausgebildete Poleschuhe beide Umlenksysteme auch als ein gemeinsames Umlenksystem ausgebildet sein können, das die Elektronen jeweils zweifach durchlaufen.

Insgesamt ist das Energiefilter als sogenanntes geradsichtiges Filter ausgebildet, d.h. die strichpunktiert dargestellte optische Achse, auf der sich ein Elektron mit der Sollenergie bewegt, ist nach Austritt aus dem Energiefilter koaxial zur optischen Achse vor Eintritt in das Energiefilter.

Das Energiefilter ist ein sogenanntes doppelt abbildendes Energiefilter. Es bildet die Eingangsbildebene (BE) achromatisch und stigmatisch in die Ausgangsbildebene (BA) ab. Gleichzeitig bildet es die Eingangsbeugungsebene (DE) stigmatisch und dispersiv in die Dispersionsebene (DA) ab. Zwischen dem zweiten Umlenkbereich (12) und dem dritten Umlenkbereich (13) entsteht noch ein stigmatisches Zwischenbild der Eingangsbildebene (BE).

Das Energiefilter weist insgesamt sieben Hexapolkorrektoren (S1 - S7) auf. Zwei erste Hexapole (S1, S7) sind dabei jeweils in der Eingangsbildebene (BE) und der Ausgangsbildebene (BA) angeordnet. Ein weiterer Hexapol (S4) ist zwischen dem zweiten und dritten Umlenksystem (12, 13) in der Symmetrieebene (M) angeordnet. Aufgrund der gewählten Positionierung dieser Hexapole entlang der optischen Achse haben diese Hexapole nur Einfluß auf die Bildfehler bei der Abbildung der Eingangsbeugungsebene (DE) in die Dispersionsebene (DA).

Jeweils zwei weitere Hexapole (S2, S3) sind zwischen dem ersten und zweiten Umlenksystem (11, 12) und dazu symmetrisch sind zwei weitere Hexapole (S5, S6) zwischen dem dritten und vierten Umlenksystem (13, 14) angeordnet. Da diese vier Hexapole in der Nähe astigmatischer Zwischenbilder der Eingangsbeugungsebene (DE) positioniert sind, haben sie nur geringe Einflüsse auf die Abbildung der Eingangsbeugungsebene in die Dispersionsebene (DA) und beeinflußen primär die bei der Abbildung der Eingangsbildebene (BE) in die achromatische Bildebene (BA) auftretenden Abbildungsfehler.

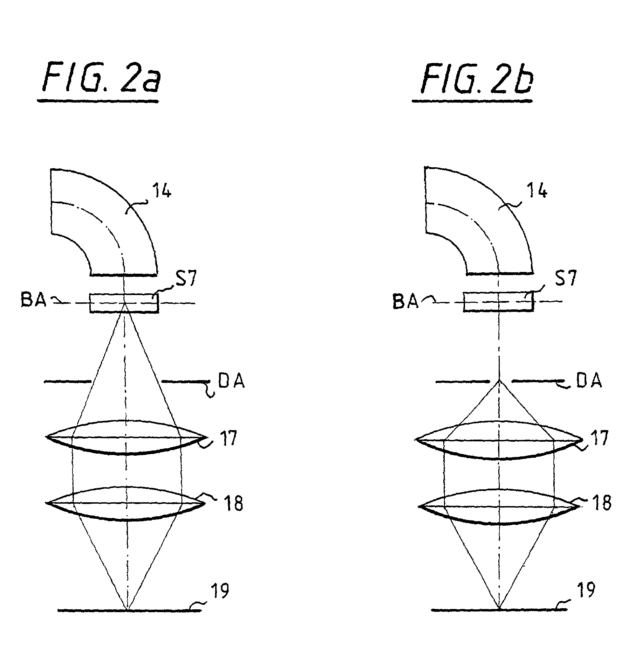

In Strahlrichtung gesehen folgt dem Energiefilter ein zweistufiges Projektivsystem (17, 18) nach. Dieses Projektivsystem (17, 18) bildet wahlweise entweder die achromatische Bildebene (BA) oder die Dispersionsebene (DA) vergrößert in die Detektorebene ab, in der eine CCD-Kamera oder CCD-Zeile (19) angeordnet ist. Die Abbildung der achromatischen Bildebene (BA) in die Detektorebene ist in der Figur 2a und die Abbildung der Dispersionsebene (DA) in die Detektorebene in der Figur 2b vergrößert dargestellt. Bei Abbildung der achromatischen Bildebene (BA) auf die CCD-Kamera wird mit der CCD-Kamera ein energiegefiltertes Objektbild oder ein energiegefiltertes Bild des Objektbeugungsdiagrammes aufgezeichnet. In der Dispersionsebene (DA) ist dann für die Energiefilterung eine Spaltblende angeordnet, durch die nur die Elektronen transmitieren, die die gewünschte Energie oder eine durch die Spaltbreite definierte Abweichung davon aufweisen.

Bei der Abbildung der Dispersionsebene (DA) auf die CCD-Kamera (19) wird das gesamte Energiespektrum der Elektronen hinter dem Energiefilter, das sogenannte Energieverlustspektrum, parallel detektiert. In diesem Fall findet in der Dispersionsebene (DA) keinerlei Energieselektion statt. Die für eine Energieselektion erforderliche Spaltblende wird dazu aus dem Strahlengang entfernt.

Bei der Objektbildaufzeichnung oder der Aufzeichnung·von Objektbeugungsdiagrammen sind die Hexapole (S1 - S7) entsprechend den aus dem eingangs genannten Aufsatz oder der eingangs genannten Dissertation bekannten Anordnungen so erregt, daß sämtliche geometrischen Aberrationen zweiter Ordnung in der achromatischen Bildebene (BA) und in der Dispersionsebene (DA) korrigiert sind. Die dafür erforderlichen, auf den Umlenkradius (Ro) in den Umlenksystemen normierten Hexapolfeldstärken (kn) entsprechend Gleichung 1 sind in der weiter unten nachfolgenden Tabelle angegeben.

$$\text{Gleichung 1:} \qquad k_n = (e/2m_0\phi^*)^{1/2}\ \Psi^{(n)}{}_{3s}\ l_n/R_0$$

In dieser Gleichung bezeichnet e die Elementarladung und $m_0$ die Ruhemasse des Elektrons. $\Phi$ ist das Beschleunigungspotential der Elektronen und $\Psi_{3s}{}^n$ das Sextupolpotential des n-ten Sextupols und $l_n$ die effektive Wirklänge des n-ten Hexapols.

Bei dieser Einstellung der Hexapole sind sämtliche geometrischen Fehler zweiter Ordnung in der achromatischen Bildebene und in der Dispersionsebene korrigiert. Gleichzeitig sind auch die chromatischen Aberrationen in der achromatischen Bildebene korrigiert, die vom Achsenabstand der Bildpunkte und von der Energieabweichung abhängig sind. Unkorrigiert sind dagegen der achsiale Farbfehler in der achromatischen Bildebene, und in der Dispersionsebene. Diese Farbfehler stören jedoch in diesem Abbildungsmode wenig, da über die in der Dispersionsebene angeordnete Selektionsblende ohnehin nur ein schmales Energiespektrum für die weitere Abbildung selektiert wird.

Bei einer Abbildung der Dispersionsebene (DA) in die Detektorebene (19) wird die Erregung von drei Hexapolen, nämlich des Hexapols (S2) unmittelbar hinter dem ersten Umlenksystem, des dazu symmetrischen Hexapols (S6) unmittelbar vor dem vierten Umlenksystem (14) und des Hexapols (S4) in der Symmetrieebene gegenläufig gegenüber der Erregung bei Abbildung der achromatischen Bildebene abgeändert. Dadurch wird nun eine Korrektur des achsialen Farbfehlers in der Dispersionsebene erreicht. Gleichzeitig bleibt weiterhin der Öffnungsfehler in der achromatischen Bildebene und in der Dispersionsebene korrigiert. Durch die Änderung der Hexapolfeldstärken sind jetzt zwar einige geometrische Bildfehler zweiter Ordnung in der achromatischen Bildebene unkorrigiert, diese Fehler sind jedoch bei der Registrierung des Spektrums wenig störend. Außerdem bleibt der achsiale Farbfehler in der achromatischen Bildebene unkorrigiert. Auch dieses stört jedoch nicht, da der Einfluß dieses Farbfehlers auf die laterale Auflösung auch bei Wahl großer Energiefenster gering bleibt.

Die erforderlichen unterschiedlichen Hexapolerregungen können für die beiden unterschiedlichen Korrektionszustände theoretisch berechnet werden. Es ist jedoch auch möglich, ausgehend vom Korrektionszustand, in dem sämtliche geometrischen Bildfehler zweiter Ordnung verschwinden, die Erregung des ersten Hexapols hinter dem ersten Umlenkbereich und des dazu symmetrischen Hexapols abzuändern und gleichzeitig die Erregung des Hexapols in der Symmetrieebene gegenläufig abzuändern, so daß zu jedem Zeitpunkt der Öffnungsfehler zweiter Ordnung verschwindet. Dazu kann in der Dispersionsebene die Kaustikfigur in dispersiver Richtung betrachtet werden, wobei die Hexapoländerungen so erfolgen, daß stets ein runder Kaustikquerschnitt auftritt. Die ermittelten Hexapolfeldstärken werden dann im Speicher eines Steuerungsrechners (15) zusammen mit den jeweils zugehörigen Erregungen des Projektivsystems (17, 18) abgespeichert. Bei einer Umschaltung des Projektivsystems (17, 18) über eine entsprechende Eingabeeinheit (16) werden dann bei einer Umschaltung des Projektivmodes gleichzeitig die Erregungen der drei Hexapole (S2, S4, S6) abgeändert. Die Eingabeeinheit für die Umschaltung (16) kann dabei entweder als hardwaremäßiger Schalter auf der Bedienungskonsole des Elektronenmikroskops oder als eine virtuelle Schaltfläche auf einem Monitor ausgebildet sein, die dann lediglich mit dem Computercursor anzufahren und mit diesem auszulösen ist.

Die konkreten konstruktiven Parameter für ein Omega-Filter sind in der nachfolgenden Tabelle I und die für die verschiedenen Betriebsmodi erforderlichen Erregungen der Hexapole sind in der nachfolgenden Tabelle II angegeben. Sämtliche Längen und Abstände sind dabei auf den Umlenkradius (Ro) in den Umlenksystemen normiert. Mit (ID) ist darin der Abstand zwischen der Eingangsbeugungsebene und der Eintrittskante des ersten Umlenkbereiches und mit (IB) der Abstand der Eingangsbildebene (BE) von der Eintrittskante des ersten Umlenkbereiches (11) bezeichnet. Mit (112) ist die Driftstrecke zwischen dem ersten Umlenkbereich (11) und dem zweiten Umlenkbereich (12) bezeichnet, also der Abstand zwischen der Austrittskante des ersten Umlenkbereiches und der Eintrittskante des zweiten Umlenkbereiches. Mit (12) ist der Abstand von der Austrittskante des ersten Umlenkbereiches (11) zur Mittenebene des zweiten Hexapols (S2) und mit (13) der Abstand zwischen der Austrittskante des ersten Umlenkbereiches (11) und der Mittenebene des dritten Hexapols (S3) bezeichnet. Mit (14) ist der Abstand zwischen der Austrittskante aus dem zweiten Umlenkbereich und der Symmetrieebene (M) bezeichnet. Alle übrigen konstruktiven Parameter ergeben sich automatisch, da das Filter spiegelsymmetrisch zur Symmetrieebene (M) aufgebaut ist. Mit ($k_1$ - $k_7$) sind die Hexapolfeldstärken der Hexapole (S1 - S7) bezeichnet. Der Umlenkwinkel beträgt in allen Umlenkbereichen (11 - 14) jeweils 90°.

Tabelle I

| Parameter | ID | IB | I12 | I2 | I3 | I4 |
|---|---|---|---|---|---|---|
| Filter | 2.33 | 0.33 | 1.88 | 0.43 | 1.04 | 0.36 |

Tabelle II

| Hexapolfeldstärken $k_n$ | S1/S7 $k_1=k_7$ | S2/S6 $k_2=k_6$ | S3/S5 $k_3=k_5$ | S4 $k_4$ | $C\gamma\gamma\kappa$ | $A_{\gamma\gamma\gamma}/B_{\gamma\delta\delta}$ |
|---|---|---|---|---|---|---|
| Filter unkorrigiert | 0 | 0 | 0 | 0 | +87 | -53.3/-34 |
| Filter in 2. Ordnung korrigiert | 4.08 | -6.8 | 26.73 | 0.64 | -60 | 0/0 |
| Korrektur $C_{\gamma\gamma\kappa}$ | 4.08 | -3.65 | 26.73 | 1.80 | -0.7 | 0/0 |

Die Erfindung wurde oben anhand eines Ausführungsbeispiels erläutert, bei dem bei Abbildung der achromatischen Bildebene in die Detektorebene die energetische Filterung über eine einfache Spaltblende erfolgt. Die Erfindung ist jedoch auch mit den in der DE 197 38 070 beschriebenen Anordnungen anwendbar, bei denen in der Dispersionsebene oder einer dazu konjugierten Ebene eine Mehrfachblende und zwischen der achromatischen Bildebene und der Dispersionsebene ein Doppelablenksystem angeordnet sind, einsetzbar. Soweit die Doppelablenksysteme und/oder die für die Zurücklenkung des Elektronenstrahls eingesetzten Magnetlinsen zusätzliche Farbfehler verursachen, sollte der achsiale Farbfehler des Filters bei Abbildung der Dispersionsebene in die Detektorebene so eingestellt werden, daß auch diese Farbfehler kompensiert werden.

**Patentansprüche**

1. Elektronenmikroskop mit einem abbildenden magnetischen Energiefilter mit symmetrisch zu einer Mittenebene (M) angeordneten magnetischen Umlenksystemen (11 - 14), Hexapolen (S2 - S6) zwischen dem Umlenksystemen (11 - 14) und einem dem Energiefilter in Strahlrichtung nachfolgenden Projektivsystem (17, 18); **gekennzeichnet dadurch, daß** wahlweise die Dispersionsebene (DA) oder die achromatische Bildebene (BA) des Filters in eine Detektorebene (19) abbildbar ist, wobei bei einer Umschaltung zwischen der Abbildung der Dispersionsebene (DA) und der Abbildung der achromatischen Bildebene (BA) eine Umschaltung der Erregung von Hexapolen (S2, S4, S6) erfolgt.

2. Elektronenmikroskop nach Anspruch 1, wobei bei Abbildung der Dispersionsebene die Hexapole (S2 - S6) so erregt sind, daß der Öffnungsfehler zweiter Ordnung und der achsiale Farbfehler des Energiefilters oder des Systems aus Energiefilter und Projektivsystem (17, 18) korrigiert sind.

3. Energiefilter nach Anspruch 2, wobei gleichzeitig anderweitige geometrische Bildfehler in der achromatischen Bildebene (BA) unkorrigiert sind.

4. Elektronenmikroskop nach einem der Ansprüche 1 - 3, wobei bei Abbildung der achromatischen Bildebene (BA) die Hexapole (S1 - S7) so erregt sind, daß sämtliche geometrischen Bildfehler in der achromatischen Bildebene (BA) und in der Dispersionsebene (DA) korrigiert sind.

5. Elektronenmikroskop nach einem der Ansprüche 1 - 4, wobei vier magnetische Umlenkbereiche (11 - 14) vorgesehen sind, und wobei zwei Hexapole (S2, S3) zwischen dem ersten und zweiten Umlenkbereich (11, 12), zwei weitere Hexapole (S5, S6) dazu symmetrisch zwischen dem dritten und vierten Umlenkbereich (13, 14) und ein zusätzlicher Hexapol (S4) in der Symmetriebene vorgesehen sind.

6. Elektronenmikroskop nach Anspruch 5, wobei bei der Umschaltung der Abbildung nur die Erregung eines der Hexapole (S2) zwischen dem ersten und zweiten Umlenkbereich, des dazu symmetrischen Hexpols (S6) zwischen dem dritten und vierten Umlenkbereich und des Hexapols (S4) in der Symmetrieebene (M) geändert wird.

7. Elektronenmikroskop nach Anspruch 6, wobei die Erregungsänderung des Hexapols (S2) zwischen dem ersten und zweiten Umlenkbereich und des dazu symmetrischen Hexapols (S6) zwischen dem dritten und vierten Umlenkbereich gegenläufig zur Erregungsänderung des Hexapols (S4) in der Symmetrieebene (M) erfolgt.

8. Elektronenmikroskop nach Anspruch 5 oder 6, wobei zwei weitere Hexapole (S1, S7) in der achromatischen Bildebene (BA) und in der dazu konjugierten eingangsseitigen Ebene (BE) des Energiefilters angeordnet sind.

9. Elektronenmikroskop nach einem der Ansprüche 6 - 8, wobei die Erregung des Hexapols (S4) in der Symmetrieebene (M) bei Abbildung der Dispersionsebene um einen Faktor 2-4, vorzugsweise um einen Faktor 2,81 größer als bei Abbildung der achromatischen Bildebene (BA) ist.

10. Elektronenmikroskop nach einem der Ansprüche 6 - 9, wobei die Erregung des ersten Hexapols (S2) hinter dem ersten Umlenkbereich (11) bei Abbildung der achromatischen Bildebene (BA) um einen Faktor 1,5 - 2,5, vorzugsweise um einen Faktor 1,87 größer als bei Abbildung der Dispersionsebene ist.

**Claims**

1. Electron microscope having an imaging magnetic energy filter with magnetic deflecting systems (11-14) arranged symmetrically relative to a centre plane (M), hexapoles (S2-S6) between the deflecting systems (11-14), and a projective system (17, 18) downstream of the energy filter in the beam direction, **characterized in that** the dispersion plane (DA) or the achromatic image plane (BA) of the filter can optionally be projected into a detector plane (19), the excitation of the hexapoles (S2, S4, S6) being switched over in the event of switching over between the projection of the dispersion plane (DA) and the projection of the achromatic image plane (BA).

2. Electron microscope according to Claim 1, in which upon projection of the dispersion plane the hexapoles (S2, S6) are excited such that the aperture aberration of second order and the axial chromatic aberration of the energy filter or the system composed of energy filter and projective system (17, 18) are corrected.

3. Energy filter according to Claim 2, in which at the same time further geometrical aberrations in the achromatic image plane (BA) are uncorrected.

4. Electron microscope according to one of Claims 1-3, in which upon projection of the achromatic image plane (BA) the hexapoles (S1-S7) are excited such that all geometrical aberrations in the achromatic image plane (BA) and in the dispersion plane (DA) are corrected.

5. Electron microscope according to one of Claims 1-4, in which four magnetic deflecting regions (11-14) are provided, and in which two hexapoles (S2, S3) are provided between the first and second deflecting regions (11, 12), two further hexapoles (S5, S6) are provided, symmetrically thereto, between the third and fourth deflecting regions (13, 14), and an additional hexapole (S4) is provided in the planar symmetry.

6. Electron microscope according to Claim 5, in which upon switching over the projection there is a change only in the excitation of one of the hexapoles (S2) between the first and second deflecting regions, the hexapole (S6) symmetrical thereto between the third and fourth deflecting regions, and the hexapole (S4) in the planar symmetry (M).

7. Electron microscope according to Claim 6, in which the change in excitation of the hexapole (S2) between the first and second deflecting regions and the hexapole (S6) symmetrical thereto between the third and fourth deflecting regions is performed in the direction opposite to the change in excitation of the hexapole (S4) in the planar symmetry (M).

8. Electron microscope according to Claim 5 or 6, in which two further hexapoles (S1, S7) arranged in the achromatic image plane (BA) and in the input plane (BE), conjugate thereto, of the energy filter.

9. Electron microscope according to one of Claims 6-8, the excitation of the hexapole (S4) in the planar symmetry (M) being greater by a factor 2 - 4, preferably by a factor 2.81, in the case of projecting the dispersion plane than in the case of projecting the achromatic image plane (BA).

10. Electron microscope according to one of Claims 6-9, the excitation of the first hexapole (S2) downstream of the first deflection region (11) being greater by a factor 1.5 - 2.5 or preferably by a factor 1.87, in the case of projecting the achromatic image plane (BA) than in the case of projecting the dispersion plane.

**EP 0 967 630 B1**

**Revendications**

1. Microscope électronique comprenant un filtre à énergie magnétique de représentation muni d'un système de déviation magnétique (11 - 14) disposé de manière symétrique par rapport à un plan médian (M), des hexapôles (S2 - S6) entre les systèmes de déviation (11 - 14) et un système de projection (17, 18) qui suit le filtre à énergie dans le sens du rayonnement, **caractérisé en ce que** le plan de dispersion (DA) ou le plan d'image achromatique (BA) du filtre peuvent, au choix, être représentés dans un plan de détection (19), une inversion de l'excitation des hexapôles (S2, S4, S6) ayant lieu en cas d'inversion entre de la représentation du plan de dispersion (DA) et la représentation du plan d'image achromatique (BA).

2. Microscope électronique selon la revendication 1, avec lequel, en cas de représentation du plan de dispersion, les hexapôles (S2 - S6) sont excités de telle manière que le défaut d'ouverture de deuxième ordre et le défaut de couleur axiale du filtre à énergie ou du système composé du filtre à énergie et du système de projection (17, 18) sont corrigés.

3. Filtre à énergie selon la revendication 2, avec lequel les défauts d'image géométriques supplémentaires qui apparaissent simultanément dans le plan d'image achromatique (BA) ne sont pas corrigés.

4. Microscope électronique selon l'une des revendications 1 à 3, avec lequel, en cas de représentation du plan d'image achromatique (BA), les hexapôles (S1 - S7) sont excités de telle manière que tous les défauts d'image dans le plan d'image achromatique (BA) et dans le plan de dispersion sont corrigés.

5. Microscope électronique selon l'une des revendications 1 à 4, avec lequel sont prévus quatre zones de déviation magnétique (11 - 14), et avec lequel sont prévus deux hexapôles (S2, S3) entre la première et la deuxième zone de déviation (11, 12), deux hexapôles (S5, S6) supplémentaires symétriques entre la troisième et la quatrième zone de déviation (13, 14) et un hexapôle supplémentaire (S4) dans le plan de symétrie.

6. Microscope électronique selon la revendication 5, avec lequel, lors de l'inversion de la représentation, seule l'excitation de l'un de hexapôles (S2) entre la première et la deuxième zone d'excitation, de l'hexapôle (S6) qui y est symétrique entre la troisième et la quatrième zone d'excitation et de l'hexapôle (S4) dans le plan de symétrie (M) est modifiée.

7. Microscope électronique selon la revendication 6, avec lequel la modification de l'excitation de l'hexapôle (S2) entre la première et la deuxième zone de déviation et de l'hexapôle (S6) qui y est symétrique entre la troisième et la quatrième zone d'excitation s'effectue à l'opposé de la modification de l'excitation de l'hexapôle (S4) dans le plan de symétrie (M).

8. Microscope électronique selon la revendication 5 ou 6, avec lequel deux hexapôles (S1, S7) supplémentaires sont disposés dans le plan d'image achromatique (BA) et dans le plan d'entrée (BE) conjugué à cet effet du filtre à énergie.

9. Microscope électronique selon l'une des revendications 6 à 8, avec lequel l'excitation de l'hexapôle (S4) dans le plan de symétrie (M), dans le cas de la représentation du plan de dispersion, est supérieure d'un facteur compris entre 2 et 4, de préférence d'un facteur 2,81, à ce qu'elle est dans le cas de la représentation du plan d'image achromatique (BA) .

10. Microscope électronique selon l'une des revendications 6 à 9, avec lequel l'excitation du premier hexapôle (S2) derrière la première zone de déviation (11), dans le cas de la représentation du plan d'image achromatique (BA), est supérieure d'un facteur compris entre 1,5 et 2,5, de préférence d'un facteur 1,87, à ce qu'elle est dans le cas de la représentation du plan de dispersion.

EP 0 967 630 B1

FIG. 1

# FIG.2a

# FIG.2b

EP 0 967 630 B1

# FIG. 3

11